(19) Europäisches Patentamt
European Patent Office
Office européen des brevets

(11) **EP 3 904 966 B1**

(12) **FASCICULE DE BREVET EUROPEEN**

(45) Date de publication et mention de la délivrance du brevet:
**07.12.2022 Bulletin 2022/49**

(21) Numéro de dépôt: **20172418.4**

(22) Date de dépôt: **30.04.2020**

(51) Classification Internationale des Brevets (IPC):
**G04C 10/04** *(2006.01)* **G04G 19/00** *(2006.01)*

(52) Classification Coopérative des Brevets (CPC):
**G04C 10/04; G04G 19/00**

(54) **DISPOSITIF INDICATEUR DE PUISSANCE D'UN GÉNÉRATEUR THERMOÉLECTRIQUE D'UNE MONTRE**

LEISTUNGSANZEIGEVORRICHTUNG EINES THERMOELEKTRISCHEN GENERATORS EINER ARMBANDUHR

DEVICE FOR INDICATING THE POWER OF A THERMOELECTRIC GENERATOR OF A WATCH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**03.11.2021 Bulletin 2021/44**

(73) Titulaire: **The Swatch Group Research and Development Ltd**
**2074 Marin (CH)**

(72) Inventeurs:
• **IMBODEN, Matthias**
**2072 St-Blaise (CH)**

• **JORNOD, Alain**
**2000 Neuchâtel (CH)**
• **HAEMMERLI, Alexandre**
**2000 Neuchâtel (CH)**

(74) Mandataire: **ICB SA**
**Faubourg de l'Hôpital, 3**
**2001 Neuchâtel (CH)**

(56) Documents cités:
**EP-A2- 3 039 492 EP-B1- 1 939 700**
**CH-B1- 701 885**

**Description**

DOMAINE TECHNIQUE DE L'INVENTION

L'invention concerne un dispositif indicateur de puissance d'un générateur thermoélectrique d'une montre, notamment pour indiquer la fourniture d'une alimentation électrique suffisante, lorsque la montre est portée par un utilisateur. Le dispositif indicateur permet d'indiquer la puissance d'un générateur thermoélectrique par une mesure de différence de températures entre une extrémité et l'autre extrémité du générateur thermoélectrique.

L'invention concerne également une montre comprenant un générateur thermoélectrique et au moins un dispositif indicateur de puissance du générateur thermoélectrique.

ETAT DE LA TECHNIQUE

L'utilisation d'un thermomètre ou thermoscope différentiel pour déterminer une différence de températures est bien connue. Cependant, aucun thermomètre différentiel analogique n'a encore été utilisé pour mesurer la puissance générée par un générateur thermoélectrique dans un objet portable, tel qu'une montre. De plus, il n'a jamais été imaginé d'ajouter un tel thermomètre différentiel à une montre, même si un thermomètre analogique dans une montre peut exister, mais sur la base d'une technologie de thermomètre à glace standard. Un tel thermomètre est jugé inutile étant donné que la température est dominée par le corps chauffant de l'utilisateur, et ainsi la température varie de manière non prédictible et aussi en fonction du changement des conditions environnementales.

La demande de brevet WO 2012/162469 A2 décrit un procédé de fabrication d'un panneau composite flexible, tel qu'une étiquette d'un produit. Ce panneau dispose de plusieurs réservoirs reliés par au moins un tube capillaire, qui a une forme avec des ondulations entre un premier réservoir et un second réservoir. Le tube capillaire est rempli d'un liquide se déplaçant en fonction de la différence de températures entre le premier réservoir et le second réservoir. Ce type de panneau composite sert avant tout comme une étiquette à placer sur un produit pour montrer une différence de températures à l'endroit où se trouve ledit produit. Un tel agencement de panneau composite flexible ne peut être ajouté dans un objet portable, tel qu'une montre, ce qui constitue un inconvénient.

Le brevet CH 701 885 B1 décrit une montre-bracelet, qui comprend dans un boîtier fermé par une glace, un mouvement horloger, et encore une pompe à fluide entraînée par le mouvement afin de pomper un fluide. Un canal, réalisé dans la glace, est prévu pour conduire le fluide mis en mouvement par la pompe de manière à afficher des informations, telles que des secondes ou la fréquence de pulsation. Le canal peut être du type tube capillaire de petite dimension. Il n'est pas prévu d'utiliser un tel tube capillaire pour afficher une information autre que celle en relation à l'heure du jour, ce qui constitue un inconvénient.

Le brevet EP 1 939 700 B1 décrit un dispositif d'affichage d'un indicateur à cadran pour une montre. L'indicateur peut être sous la forme d'au moins une aiguille pour afficher une information. La ou les aiguilles de l'indicateur sont des aiguilles des heures et des minutes et peuvent être contrôlées par un moyen de commande pour afficher une information spécifique généralement liée au temps. Il est aussi décrit un procédé pour détecter si la montre est portée au poignet d'une personne, par exemple en détectant la puissance de sortie d'un générateur interne, qui est un générateur thermoélectrique. Cependant, rien n'est décrit concernant un indicateur visuel sous une forme autre qu'une ou plusieurs aiguilles pour afficher une différence de températures d'un générateur thermoélectrique notamment sur un cadran de la montre ou sur un autre endroit, ce qui constitue un inconvénient.

RESUMÉ DE L'INVENTION

L'invention a donc pour but de pallier les inconvénients cités ci-dessus avec un dispositif indicateur de puissance d'un générateur thermoélectrique.

A cet effet, l'invention concerne un dispositif indicateur de puissance d'un générateur thermoélectrique, qui comprend les caractéristiques de la revendication indépendante 1.

Des formes d'exécution particulières du dispositif indicateur sont définies dans les revendications dépendantes 2 à 18.

Un avantage du dispositif indicateur de puissance d'un générateur thermoélectrique réside dans le fait que le générateur thermoélectrique génère de la puissance en quelques secondes lorsque la montre est portée. Ainsi il peut être mesuré une différence de températures d'un côté à l'autre du générateur thermoélectrique facilement et rapidement. Grâce à un indicateur visuel disposé de préférence au niveau d'un cadran de montre, cela permet de visionner de suite la puissance générée du générateur thermoélectrique.

Avantageusement, l'indication de la différence de températures (gradient thermique) pour déterminer la puissance générée par le générateur thermoélectrique, est de type analogique par le dispositif indicateur. De ce fait, il consomme moins de puissance qu'une indication numérique sur un dispositif d'affichage traditionnel. Le dispositif indicateur proposé utilise une petite fraction de la puissance disponible et par conséquent ne dégrade pas le rendement de l'énergie prélevée ou extraite du générateur thermoélectrique.

Avantageusement, même si le générateur thermoélectrique ne génère aucune alimentation, le dispositif indicateur fonctionne toujours et indique dans ce cas une différence de températures égale à 0 une fois calibré.

Ceci n'est pas possible pour un système alimenté par l'électricité fournie par le générateur thermoélectrique. Ainsi, le dispositif indicateur est purement analogique et de plus, peut être encore plus esthétique qu'un affichage numérique.

Avantageusement, le dispositif indicateur peut avoir une portion d'affichage linéaire ou non linéaire, en adaptant par exemple la forme du tube capillaire contenant une huile d'affichage. Il peut même être envisagé d'avoir une portion logarithmique ou hyperbolique de la portion d'affichage. Ce dispositif indicateur est donc fort simple avec uniquement quelques parties et sans avoir de parties extérieures qui bougent et qui peuvent s'user.

La simplicité d'un thermomètre différentiel est une force. En comparaison à une approche électromécanique pour mesurer le courant ou tension fourni par le générateur TEG, un tel dispositif indicateur n'est pas affecté par tout champ magnétique et est également plus résistant aux chocs mécaniques.

A cet effet, l'invention concerne une montre comprenant un générateur thermoélectrique et au moins un dispositif indicateur de puissance du générateur thermoélectrique selon la revendication indépendante 19.

Des formes d'exécution particulières de la montre sont définies dans les revendications dépendantes 20 et 21.

BRÈVE DESCRIPTION DES FIGURES

Les buts, avantages et caractéristiques du dispositif indicateur de puissance d'un générateur thermoélectrique apparaîtront mieux dans la description suivante sur la base de formes d'exécution non limitatives illustrées par les dessins sur lesquels :

- la figure 1 représente une vue de côté d'une forme d'exécution selon l'invention d'un dispositif indicateur de puissance d'un générateur thermoélectrique relié d'un côté et de l'autre côté du générateur thermoélectrique,

- les figures 2a, 2b et 2c représentent une vue depuis dessus d'une montre qui comprend le dispositif indicateur de puissance du générateur thermoélectrique vu sur un cadran de montre selon l'invention,

- la figure 3 représente une vue d'une forme d'exécution de la portion d'affichage entre deux réservoirs d'air du dispositif indicateur à conduite tubulaire de type capillaire contenant un liquide coloré et qui a une forme particulière avec une indication sur sa longueur d'une part linéaire et d'autre part non linéaire de la différence de températures selon l'invention,

- la figure 4 représente une vue générale d'une forme d'exécution du dispositif indicateur en entier et qui comprend une portion d'affichage comme représentée à la figure 3 précédente,

- la figure 5 représente une vue de dessus de la montre au niveau du cadran à travers lequel une fenêtre est réalisée sur la portion d'affichage du dispositif indicateur selon l'invention pour montrer la puissance générée par le générateur thermoélectrique,

- la figure 6 représente une vue tridimensionnelle schématique d'une première forme d'exécution du dispositif indicateur selon l'invention ayant deux réservoirs de fluide gazeux reliés par une conduite tubulaire de type capillaire, et disposant de moyens pour calibrer l'indication affichée par le liquide dans la conduite tubulaire de type capillaire à l'état initial,

- la figure 7 représente une vue tridimensionnelle schématique d'une seconde forme d'exécution du dispositif indicateur selon l'invention ayant deux réservoirs de fluide gazeux reliés par une conduite tubulaire de type capillaire, et disposant de moyens pour calibrer l'indication affichée par le liquide dans la conduite tubulaire de type capillaire à l'état initial,

- la figure 8 représente une vue tridimensionnelle schématique d'une variante d'exécution du dispositif indicateur selon l'invention présentée aux figures 6 et 7,

- les figures 9a, 9b, 9c représentent une vue de côté et deux vues de dessus d'une chambre micro fluidique, qui comprend la portion d'affichage du dispositif indicateur selon l'invention,

- la figure 10 représente une variante d'exécution des formes d'exécution présentées aux figures 9a, 9b et 9c, et

- la figure 11 représente une vue de dessus de la montre au niveau du cadran à travers lequel une fenêtre est réalisée sur la portion d'affichage du dispositif indicateur selon l'invention avec la chambre micro fluidique présentées aux figures 9a, 9b et 9c.

DESCRIPTION DETAILLEE DE L'INVENTION

Dans la description suivante, il est décrit un dispositif indicateur de la puissance d'un générateur thermoélectrique, sans entrer trop dans le détail de la manière du fonctionnement dudit générateur thermoélectrique, qui est bien connu dans ce domaine technique, et ne fait pas partie directement du dispositif indicateur.

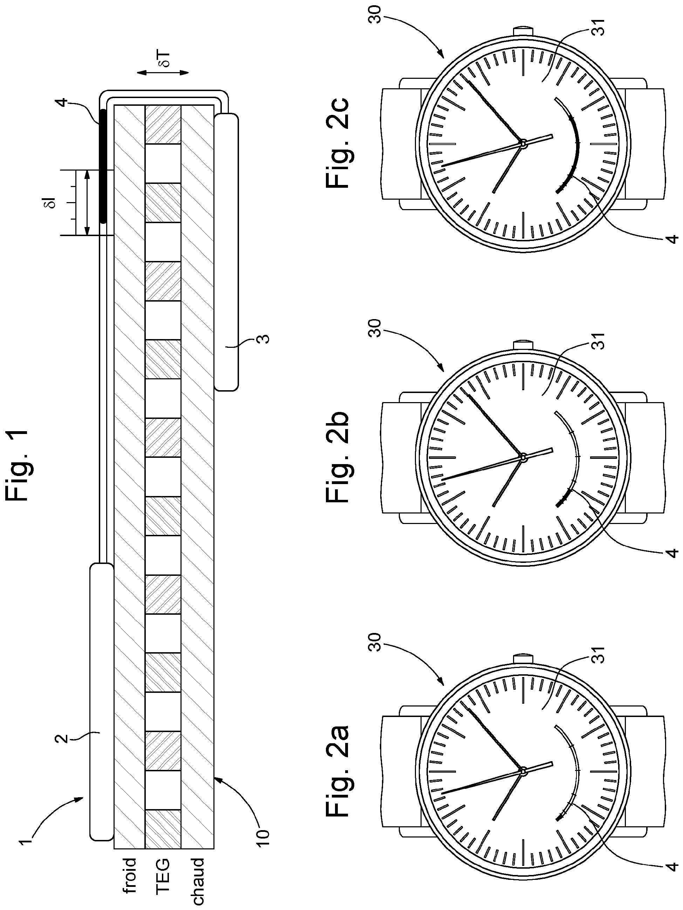

La figure 1 représente un dispositif indicateur 1 de puissance d'un générateur thermoélectrique 10 de préférence monté dans une montre. Le dispositif indicateur 1 est relié par exemple à une surface de dessous et une surface de dessus du générateur thermoélectrique 10 de manière à effectuer une mesure de différence de températures entre ces deux surfaces, ce qui détermine la puissance du générateur. La surface de dessous du générateur thermoélectrique 10 est directement liée à un fond métallique d'une boîte de montre de manière à venir en contact du poignet d'un utilisateur de la montre qui la porte. De cette manière la surface de dessous de générateur thermoélectrique est à une température voisine de celle de la température du poignet de l'utilisateur. Par contre, la surface de dessus est de préférence bien à l'intérieur de la boîte de montre et n'a donc pas une même température que la surface de dessous. Une différence de températures δT entre ces deux surfaces peut être mesurée par le dispositif indicateur 1 pour indiquer la puissance générée par le générateur thermoélectrique. Cette différence de températures δT peut être par exemple entre 1 à 10°C, mais peut aussi être supérieure selon la température du poignet de l'utilisateur et par rapport à la température intérieure du centre de la boîte de montre.

Un tel générateur thermoélectrique 10 génère habituellement de la puissance en quelques secondes quand la montre est portée. Comme la montre est typiquement en marche, il n'y a évidemment pas d'indication concernant le fonctionnement du générateur thermoélectrique. C'est pourquoi il est prévu un tel dispositif indicateur 1 selon l'invention monté dans la montre pour visualiser à l'extérieur de la montre la puissance générée par le générateur thermoélectrique dans un mode actif.

La solution de l'invention proposée avec ce dispositif indicateur 1 consiste à définir que la puissance générée par le générateur thermoélectrique est proportionnelle à la différence de températures entre la surface supérieure et la surface inférieure dudit générateur thermoélectrique. Cependant, il est nécessaire d'afficher le différentiel en température pour afficher précisément la puissance instantanée générée. A cette fin, un thermomètre différentiel est présenté sous la forme du dispositif indicateur 1, qui est réalisé pour être adapté à l'affichage d'un gradient thermique existant dans une montre une fois portée.

Ce dispositif indicateur 1 (thermomètre différentiel) se base sur une construction comprenant deux réservoirs 2, 3 remplis d'un fluide, qui est de préférence un fluide gazeux, les réservoirs 2, 3 étant reliés par une conduite tubulaire 4 de type capillaire, qui contient un liquide, tel qu'un liquide huileux ou alcool, formant une barrière entre les deux réservoirs 2, 3. Un premier réservoir 2 peut être placé sur la surface supérieure du générateur thermoélectrique 10, alors qu'un second réservoir 3 peut être placé sur la surface inférieure du générateur thermoélectrique 10. Comme le fluide gazeux contenu dans le second réservoir 3 devient plus chaud que le fluide gazeux contenu dans le premier réservoir 2, lorsque la montre est portée par un utilisateur, le liquide huileux ou alcool de la conduite tubulaire 4 a tendance à se déplacer en direction du premier réservoir 2. Ainsi, le liquide huileux ou alcool peut bouger librement à l'intérieur de la conduite tubulaire 4 en changeant le volume de fluide gazeux d'un côté ou de l'autre en fonction de la différence de températures. Dans un état stable, les deux volumes de fluide gazeux peuvent être identiques, ce qui signifie que le contenu de chaque réservoir peut être de préférence identique. Le volume de fluide gazeux contenu dans le premier réservoir 2 et jusqu'au liquide huileux ou alcool, ainsi que le volume de fluide gazeux contenu dans le second réservoir 3 et jusqu'au liquide huileux ou alcool peuvent être identiques à une même température. Comme les deux réservoirs 2, 3 sont des chambres rigides, n'importe quel changement de volume de fluide gazeux est seulement possible, si le liquide bouge dans la conduite tubulaire 4, ce qui donne l'indication désirée d'un gradient thermique.

Le liquide utilisé dans la conduite tubulaire 4 a certaines contraintes. Il doit être incompressible, de faible viscosité et de faible pression vapeur. Une contrainte supplémentaire est que le liquide et le gaz doivent être appariés de sorte que le gaz ne puisse se dissoudre dans le liquide. Il est clair également qu'un colorant est nécessaire pour le liquide pour bien le distinguer dans la portion d'affichage 24. Le colorant ne doit pas coaguler ou de n'importe quelle façon précipiter avec le liquide. S'il est d'une faible affinité aux parois capillaires, il peut être difficile de remplir la conduite tubulaire 4 avec le liquide. Dans le cas contraire, il peut s'étaler sur les parois capillaires à l'intérieur de la conduite tubulaire 4 et ne reste pas cohérent. Le liquide utilisé peut donc être un alcool, tel que de l'éthanol ou méthanol, ou une substance, telle que de l'hydrocarbure ou du toluène. Le liquide peut aussi être un liquide huileux. On peut imaginer également d'introduire dans le liquide des molécules fluorescentes ou phosphorescentes pour permettre de visionner même dans la nuit l'indication de la puissance du générateur thermoélectrique.

Une alternative est d'avoir une couche spécifique déposée à l'intérieur ou plus simplement à l'extérieur de la conduite, dont l'interaction optique avec le liquide permet de visualiser via leur indice spécifique de réfraction la position exacte du liquide. Ce type de combinaison optique est bien connu pour d'autres types d'indicateurs, et sont également applicables ici.

Le fluide gazeux utilisé dans les réservoirs 2, 3 peut-être un gaz, tel que l'azote, le dioxyde de carbone $CO_2$, ou l'argon, qui est en gaz noble plus inerte et probablement le meilleur. L'hélium peut aussi être utilisé, car il est bon en termes de conductivité thermique et charges de chaleur, mais peut être difficile à piéger. L'oxygène doit être évité, étant donné qu'il est très réactif. Bien évidemment, il est préférable d'avoir le même gaz pour les deux réservoirs 2, 3.

Selon l'agencement des deux réservoirs 2, 3 sur le générateur thermoélectrique 10 comme présenté à la figure 1, la conduite tubulaire 4 peut comprendre des parties ou portions flexibles entre le premier réservoir 2 et le second réservoir 3 pour faciliter le montage du dispositif indicateur 1. Le diamètre intérieur de ces portions flexibles peut-être entre 50 et 100 μm. Bien entendu, il n'est présenté qu'une forme d'exécution simplifiée sur cette figure 1, mais d'autres formes peuvent tout à fait être envisagées. Une portion intermédiaire de la conduite tubulaire 4, où se trouve en partie le liquide huileux ou alcool, permet de fournir une indication d'un gradient thermique sur une partie graduée δl, qui peut être inscrite par exemple sur un cadran de la montre. Le diamètre intérieur de cette portion intermédiaire de la conduite tubulaire peut être entre 0,1 et 0,5 mm et dépend du liquide introduit dans cette portion intermédiaire de manière à servir de barrière au fluide gazeux. Chaque échelle de graduation δl peut être par exemple définie à 2,6 mm/°C, mais bien d'autres graduations peuvent aussi être appliquées pour afficher ce gradient thermique.

Les deux réservoirs 2, 3, qui sont présentés ici de forme parallélépipédique, peuvent avoir pour le fluide gazeux un volume par exemple de l'ordre de 10 à 100 mm$^3$. La conduite tubulaire 4 reliant les deux réservoirs peut avoir un volume négligeable en comparaison, et les gradients thermiques de la conduite tubulaire 4 peuvent être négligés. Le diamètre intérieur de la conduite tubulaire 4 est critique, ce qui peut être la base du changement volumétrique. Le diamètre intérieur de la conduite tubulaire 4 (ID) est aussi important, étant donné qu'il définit la partie visuelle du dispositif indicateur 1 visible de l'extérieur de la montre.

Selon une première approximation linéaire, on peut exprimer par exemple le changement dans le volume donné des deux réservoirs 2, 3 par un changement de la température comme :

$$\delta V(\delta T) = \frac{V_0}{2T_0} \delta T$$

où $V_0$ est le volume (identique pour les deux réservoirs dans ce cas) à la température To. Dû à une différence de températures δT entre les réservoirs chaud et froid 2, 3, la position de la goutte d'huile colorée est ainsi donnée comme :

$$\delta l(\delta T) = \frac{\delta V}{\pi \left(\frac{ID}{2}\right)^2} = \frac{V_0}{2\pi \left(\frac{ID}{2}\right)^2} \frac{\delta T}{T_0}$$

Dans le cas d'un modeste volume de 49 mm$^3$ pour chaque réservoir 2, 3, et une conduite tubulaire 4 de type capillaire avec un diamètre intérieur de 0,2 mm, on doit s'attendre que l'élément indicateur (liquide huileux ou alcool) puisse être affiché avec une graduation de 2,6 mm/°C. De plus, durant l'opération à l'état stable de la montre à générateur thermoélectrique, δT peut être par exemple entre 1 à 10°C. Lorsque la montre est placée au poignet d'un utilisateur, le second réservoir 3 du côté du fond de la boîte de montre est au niveau du contact de la peau. On observe ainsi un changement soudain en température, dont le gradient thermique peut atteindre 10° C.

Les figures 2a, 2b et 2c représentent une vue de face depuis dessus d'une montre 30, qui comprend le dispositif indicateur de puissance du générateur thermoélectrique. Une portion d'affichage de la conduite tubulaire 4, qui comprend le liquide huileux ou alcool de préférence coloré, est visible sur le cadran 31 de la montre 30. Cette portion d'affichage définit une partie circulaire centrée sur l'axe central de la montre 30. La portion d'affichage peut être disposée sur le cadran 31 de montre 30 ou en dessous en étant visible à travers une fenêtre traversante du cadran 31 de montre 30. Une graduation est effectuée sur le cadran 31 à proximité de la portion d'affichage de la conduite tubulaire 4.

Sur la figure 2a, on remarque que le liquide huileux ou alcool coloré venant depuis la gauche s'arrête à une position initiale 0 d'une graduation, qui peut être définie en nW ou en δT dans ce cas de figure. Cela signifie que les deux réservoirs avec leur fluide gazeux sont soit à une même température, soit que la montre 30 est laissée au repos sans être portée au poignet d'un utilisateur.

Sur la figure 2b, on remarque que le liquide huileux ou alcool a bougé vers la droite légèrement sur une position indiquant par exemple 2 δT. Cela signifie que la montre 30 est dans un état stable, c'est-à-dire que la montre 30 est portée depuis un certain temps au poignet d'un utilisateur.

Sur la figure 2c, on remarque que le liquide huileux ou alcool coloré a fortement bougé vers la droite sur une position indiquant par exemple 16 δT. Cela signifie que la montre 30 vient d'être mise autour du poignet d'un utilisateur. Le second réservoir chauffe plus vite que le premier réservoir dans la boîte de montre 30. Ainsi, il y a un changement brutal de température au niveau du second réservoir, ce qui conduit à une puissance supérieure de ce qu'elle devrait être à l'état stable.

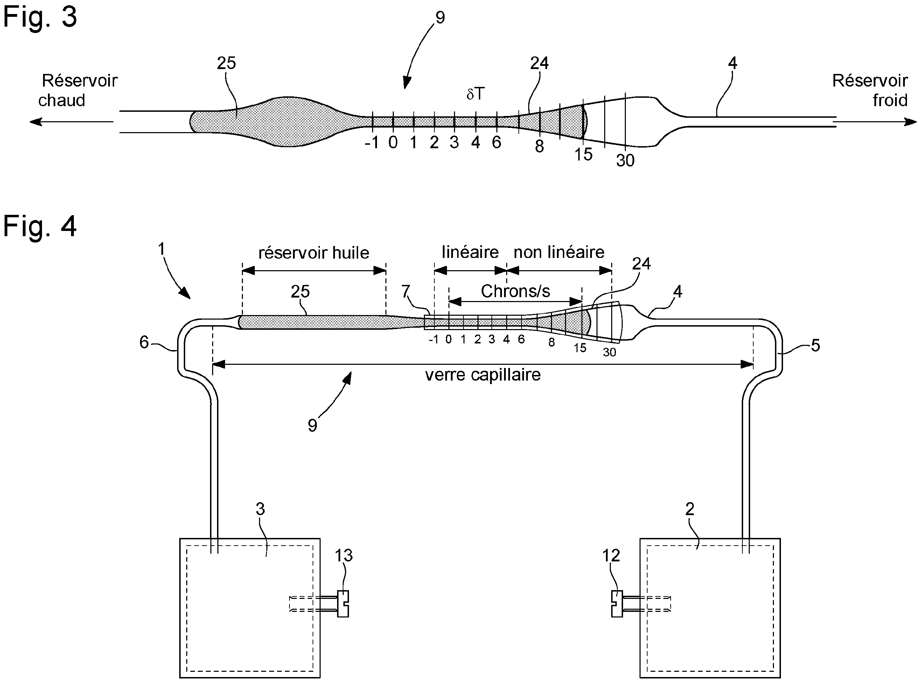

La figure 3 représente une vue d'une forme d'exécution d'une portion intermédiaire 9 de la conduite tubulaire 4, qui comprend une portion d'affichage 24 entre deux réservoirs de fluide gazeux, tel que de l'air, du dispositif indicateur. Le réservoir chaud se trouve du côté gauche de la portion intermédiaire 9, alors que le réservoir froid se trouve du côté droit de la portion intermédiaire 9. La portion intermédiaire 9 de forme tubulaire s'étend dans une direction rectiligne de son entrée en direction du réservoir chaud, à sa sortie en direction du réservoir froid. Au niveau de la portion intermédiaire 9 de la conduite tubulaire 4, on remarque la forme particulière de la conduite tubulaire 4, qui varie de la partie gauche à la partie droite visible. De préférence, cette portion intermédiaire 9 de la conduite tubulaire 4 peut être réalisée dans un matériau, tel que du verre ou du saphir, qui est transparent pour voir le liquide par exemple coloré de l'extérieur de la montre.

Le matériau de la portion intermédiaire 9 doit être choisi en fonction du liquide introduit dans la conduite tubulaire 4 de type capillaire. La surface intérieure du verre ou saphir peut être adaptée au liquide introduit dans la portion intermédiaire 9. Cependant, il est avantageux de ne pas requérir de traitement de surface particulier dans cette portion intermédiaire 9, car cela devient difficile à contrôler dans ses rapports géométriques petits et peut se dégrader dans le temps. En lieu et place du verre ou saphir, il peut être choisi comme matériau de la portion intermédiaire 9 divers polymères, thermoplastiques, élastomères, hydrogels, voire du silicium, qui peut être travaillé.

Cette portion intermédiaire 9 contient un liquide huileux ou alcool coloré et a une forme particulière avec une indication de graduation sur la longueur de la portion d'affichage 24 d'une part linéaire et d'autre part non linéaire de la différence de températures. Cette graduation est de préférence appliquée sur le cadran de montre. La portion intermédiaire 9 comprend en liaison à la portion d'affichage 24 du côté du réservoir chaud, un réservoir de liquide 25 prenant la forme d'une grosse goutte. Dans le réservoir de liquide 25, il est prévu suffisamment de liquide pour assurer un volume rempli pour l'affichage de l'indication de puissance dans la portion d'affichage 24 du dispositif indicateur.

Le second réservoir du dispositif indicateur est le réservoir chaud, alors que le premier réservoir du dispositif indicateur est le réservoir froid. Selon la différence de températures entre les deux réservoirs, le volume de fluide gazeux du côté du réservoir chaud est plus important que le volume de fluide gazeux du côté du réservoir froid. Ainsi, il est représenté le liquide huileux ou alcool, qui s'est déplacé sur la graduation 15 ou 16, qui peut être exprimée en $\delta T$, comme représenté à la figure 2c précédente. Depuis l'indication 6, qui peut être exprimée en $\delta T$, le diamètre intérieur de la conduite tubulaire 4 peut augmenter linéairement en direction du réservoir froid. Cela permet d'avoir une portion d'affichage 24 moins longue en fonction du gradient thermique mesuré.

Il est à noter qu'un diamètre intérieur ID constant de la conduite tubulaire 4 se traduit par une échelle linéaire, car la variation de volume dépend linéairement de la position du liquide comme $\delta V = \pi \cdot (ID/2)^2 \cdot \delta l$. Toute autre échelle, y compris parabolique ou logarithmique, peut être construite en faisant varier le diamètre intérieur ID en fonction de la position le long de l'échelle. Par exemple, une échelle logarithmique est obtenue en mettant à l'échelle le diamètre intérieur ID de sorte que $\delta V \sim \log(\delta l)$. Le diamètre intérieur de la conduite tubulaire 4 peut varier à un taux pré-choisi par rapport à la distance résultante dans une échelle linéaire, logarithmique ou hyperbolique comme souhaité.

La figure 4 représente de manière schématique tous les éléments du dispositif indicateur 1. On retrouve sur cette figure 4, une portion intermédiaire 9 de la conduite tubulaire 4 de type capillaire, sensiblement similaire à celle présentée à la figure 3 décrite ci-dessus. Le réservoir de liquide 25, qui peut être de l'huile, est sous une forme cylindrique d'un diamètre intérieur supérieur au diamètre intérieur de la partie linéaire de forme cylindrique de la portion d'affichage 24. Ceci permet d'assurer un volume rempli d'huile pour l'affichage de l'indication de puissance dans la portion d'affichage 24.

Selon une variante de réalisation représentée sur cette figure 4, cette portion d'affichage 24 peut être visible à travers une fenêtre 7 réalisée dans le cadran de montre, étant donné que tous les éléments du dispositif indicateur se trouvent en dessous du cadran de montre. Cependant, il peut être imaginé que la portion d'affichage 24 est disposée sur le cadran de montre, et dans ce cas, aucune fenêtre 7 n'est réalisée dans le cadran, mais uniquement deux trous pour le passage de la portion d'affichage 24.

La portion intermédiaire 9 est de préférence réalisée en verre ou en saphir. A la sortie de la portion d'affichage 24, une première portion tubulaire flexible 5 de la conduite tubulaire 4 relie la portion d'affichage 24 au premier réservoir 2 de fluide gazeux. De même à la sortie du réservoir de liquide 25, qui est l'entrée de la portion intermédiaire 9, une seconde portion tubulaire flexible 6 de la conduite tubulaire 4 relie le réservoir de liquide 25 au second réservoir 3 de fluide gazeux. Les deux portions tubulaires flexibles 5, 6 et la portion intermédiaire 9 forment ensemble la conduite tubulaire 4 de type capillaire. Le diamètre intérieur de ces portions flexibles 5, 6 peut être même inférieur au diamètre intérieur de la partie linéaire de la portion d'affichage 24. Bien entendu, comme non représenté précisément à la figure 4, le premier réservoir 2 est monté sur une surface supérieure du générateur thermoélectrique, alors que le second réservoir 3 est monté sur une surface inférieure du générateur thermoélectrique du côté du fond de la boîte de montre comme montré à la figure 1.

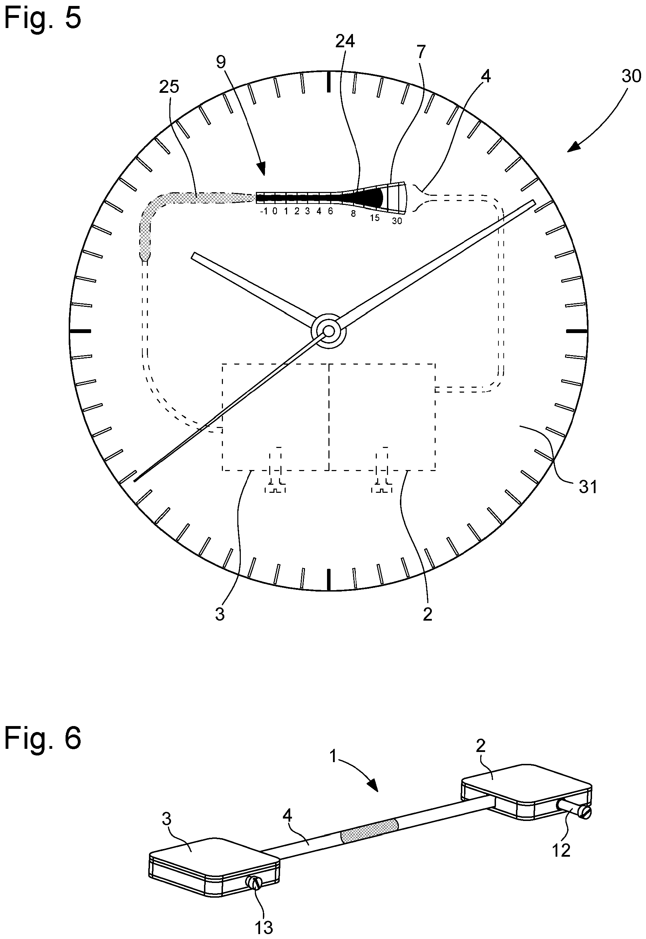

Il est encore à noter que le premier réservoir 2 comprend encore une vis 12 comme moyen de réglage du volume du fluide gazeux à l'intérieur du premier réservoir 2. Le second réservoir 3 comprend également une vis 13 comme moyen de réglage du volume du fluide gazeux à l'intérieur du second réservoir 3, comme il sera expliqué plus en détail à la figure 6 ci-après.

Il est à noter que si on prend des unités, qui ne sont pas particulièrement naturelles, telles que [nW] et [$\delta T$], il n'y a pas de traduction intuitive vers une mesure utile. Il peut donc être proposé de définir l'unité « Chron », qui représente l'unité d'énergie nécessaire au moteur Lavet pour avancer d'un pas. Dans le cas d'une montre avec une seconde aiguille, la consommation d'énergie est de 1 Chron/s. Cela peut donc être indiqué sur l'échelle en remplacement de l'unité nW ou $\delta T$. Ainsi, lorsque l'indicateur est à « 1 Chron/s », il y a autant d'énergie générée par le générateur TEG, que celle consommée par le moteur Lavet pour maintenir la montre en marche. Pour un utilisateur type, l'état stable peut être à « 3 Chrons/s » : 1 Chron/s est utilisé pour maintenir la montre en marche, les 2 Chrons/s restants sont stockés dans la batterie pour une utilisation ultérieure.

Dans le cas de l'effet de gravité, la pression exercée par le liquide dans la conduite tubulaire 4, on a $\delta P = \rho \cdot g \cdot h$, où h est la longueur de la goutte de liquide de densité p. C'est compensé par un changement dans le volume $\delta V = \delta l \cdot \pi \cdot (ID/2)^2$. Etant donné que $2 \cdot \delta V =$

$\delta P \cdot (V/P)$, on trouve $\delta l = (2 \cdot V/(\pi \cdot P \cdot ID^2)) \cdot \rho \cdot g \cdot h = 75$ µm par mm de liquide. Cependant, on peut imaginer une variation de l'ordre de 1 mm du positionnement de la goutte, lorsqu'on retourne la montre. Mais étant donné ce qui est typique, la montre sera regardée lorsqu'elle est dans un plan horizontal, on peut faire un design du chemin, tel que la hauteur dans l'expression ci-dessus et minimisée typiquement de l'ordre de quelques millimètres, alors la variation du positionnement de la goutte, si on tourne la montre, reste inférieure à 300 µm.

Selon un cours thermique, la résistance thermique du verre capillaire peut être comparée à la résistance thermique du générateur thermoélectrique. Cela donne le rapport de flux thermique perdu au dispositif indicateur 1 en comparaison au générateur thermoélectrique 10, qui génère l'énergie nécessaire.

Au niveau de la portion d'affichage 24, le verre capillaire peut être de diamètre externe de 1 mm, de longueur $L_c$ égale à 10 mm et de conductivité thermique $\lambda$ = 1 W/(m·K), qui présente une résistance thermique $R_{cap}$ = $(4 \cdot L_c)/(\lambda \cdot \pi \cdot OD^2)$ = 12'700 K/W placée en parallèle avec le générateur thermoélectrique de la résistance thermique $R_{teg}$.

La résistance thermique équivalente de $R_{cap}$ et $R_{teg}$ en parallèle est $R_{par} = R_{cap} \cdot R_{teg}/(R_{cap}+R_{teg})$. Pour un générateur TEG 10 adapté à la montre, la résistance thermique $R_{teg}$ = 100 K/W menant à $R_{par}$ = $R_{cap} \cdot R_{teg}/(R_{cap}+R_{teg})$ = 99.2 K/W et la perte thermique est ainsi typiquement plus basse que 1 % et pas mesurable dans le système proposé.

La figure 5 représente une vue de dessus de la montre 30 au niveau du cadran 31 à travers lequel une fenêtre 7 est réalisée sur la portion d'affichage 24 du dispositif indicateur. Cette portion d'affichage 24 permet de montrer la puissance générée par le générateur thermoélectrique suite à une différence de températures entre le premier réservoir 2 et le second réservoir 3. La portion intermédiaire 9 comprend encore un réservoir d'huile 25, qui est sous le cadran 31 entre la portion d'affichage 24 et le second réservoir 3. Bien entendu, comme indiqué précédemment, le premier réservoir 2 peut ne pas être dans le même plan que le second réservoir 3 dans la boîte de montre 30.

La figure 6 représente une vue tridimensionnelle simplifiée d'une première forme d'exécution du dispositif indicateur 1 selon l'invention ayant deux réservoirs 2, 3 de fluide gazeux reliés par une conduite tubulaire 4 de type capillaire. On peut observer le liquide huileux ou alcool, qui se trouve dans la portion intermédiaire de la conduite tubulaire 4. Cette première forme d'exécution a déjà été décrite ci-dessus en référence à la figure 4. Des moyens de réglage du volume de fluide gazeux dans les réservoirs 2, 3 sont prévus pour calibrer l'indication affichée par le liquide dans la portion intermédiaire de la conduite tubulaire 4. De préférence, les deux réservoirs 2, 3 sont de forme et de contenu identiques, ce qui signifie qu'à l'état initial, le liquide dans la portion intermédiaire doit se trouver dans une position centrale de la conduite tubulaire 4. Pour ce faire, le premier réservoir 2 comprend une première vis de réglage 12, alors que le second réservoir 3 comprend une seconde vis de réglage 13. En vissant ou dévissant au moins une des vis 12, 13 vers l'intérieur ou l'extérieur de la chambre des réservoirs 2, 3, le volume de fluide gazeux est ajusté pour effectuer une calibration de la position du liquide dans la conduite tubulaire 4, lorsque la température dans les deux réservoirs 2, 3 est identique, ou la différence de températures est connue.

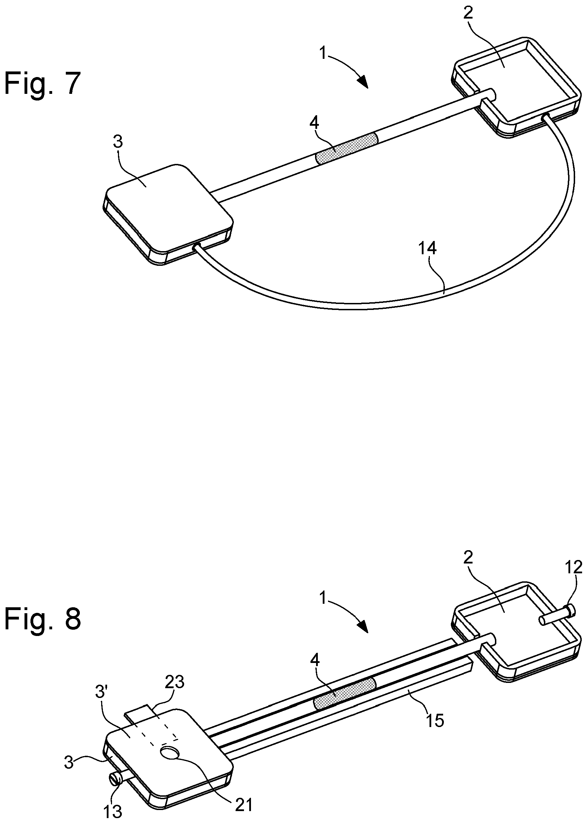

La figure 7 représente une vue tridimensionnelle simplifiée d'une seconde forme d'exécution du dispositif indicateur 1 selon l'invention ayant deux réservoirs 2, 3 de fluide gazeux reliés par une conduite tubulaire 4 de type capillaire, dans laquelle on peut observer le liquide huileux ou alcool qui se trouve dans la portion intermédiaire de la conduite tubulaire 4. Cette partie de cette seconde forme d'exécution est identique à la première forme d'exécution décrite ci-dessus en référence à la figure 6. Par contre, d'autres moyens de réglage du volume de fluide gazeux dans les réservoirs 2, 3 sont prévus pour calibrer l'indication affichée par le liquide dans la portion intermédiaire de la conduite tubulaire 4. Comme précédemment, les deux réservoirs 2, 3 sont de forme et de contenu identiques, ce qui signifie qu'à l'état initial, le liquide dans la portion intermédiaire doit se trouver dans une position centrale de la conduite tubulaire 4.

Les moyens de réglage sont constitués dans cette seconde forme d'exécution par une dérivation tubulaire 14, qui peut être en partie flexible sur sa longueur, et qui relie la chambre du premier réservoir 2 à la chambre du second réservoir 3. Comme montré à la figure 7, un capot de fermeture de la chambre du premier réservoir 2 a été retiré de manière à montrer la forme de la chambre intérieure. Si une chambre d'un réservoir est chauffée pendant l'assemblage avec le liquide se déplaçant dans la portion intermédiaire de la conduite tubulaire 4, on peut ajuster la position du liquide à l'aide de la dérivation tubulaire 14, même lorsque le réservoir est fermé. L'idée est que la dérivation tubulaire 14 peut être écrasée, ce qui peut isoler les deux côtés. Ensuite, en écrasant sélectivement la dérivation tubulaire 14, on peut pousser le fluide gazeux dans l'une et/ou l'autre chambre et déplacer le liquide indicateur précisément, un peu comme dans une pompe péristaltique. Cela permet donc de régler finement le volume de fluide dans chaque chambre et de ce fait, positionner précisément le liquide indicateur. Ainsi, une opération de calibration de la position du liquide dans la conduite tubulaire 4 peut être effectuée initialement. Cette opération n'est pas trop difficile à effectuer, étant donné que le fluide gazeux, tel que de l'air, dans les deux chambres des réservoirs 2, 3 peut être à la pression atmosphérique. La dérivation tubulaire 14 peut éventuellement être retirée après calibration en bouchant les trous de liaison aux chambres des réservoirs 2, 3.

La figure 8 représente une variante de réalisation des figures 6 et 7, dans laquelle il est prévu également en dessous de la conduite tubulaire 4 de type capillaire transparente, un miroir 15 ayant une rainure longitudinale semi cylindrique de forme complémentaire à la conduite tubulaire 4. Cette conduite tubulaire 4 est disposée dans la rainure longitudinale du miroir 15, de manière à améliorer la visibilité du liquide dans la portion d'affichage du dispositif indicateur pour indiquer la différence de températures et donc la puissance générée par le générateur thermoélectrique.

Le dispositif indicateur de la figure 8 présente encore comme moyen de réglage une ouverture traversante 21, qui est réalisée dans le capot ou couvercle 3' du second réservoir 3 de manière à amener un fluide gazeux par cette ouverture 21 pour le réglage de la position du liquide dans la portion intermédiaire de la conduite tubulaire 4. Il est encore prévu une plaque de fermeture 23 pouvant coulisser dans le capot 3' du second réservoir 3 pour fermer l'ouverture traversante 21 une fois que la position du liquide est bien définie dans la portion intermédiaire. Il en est de même pour le premier réservoir, où il peut être prévu une ouverture traversante non représentée, qui est réalisée dans le capot, qui ferme la chambre du premier réservoir. Une plaque de fermeture est également prévue dans le capot du premier réservoir pour fermer l'ouverture traversante de ce capot une fois la position du liquide bien définie dans la portion intermédiaire.

Il est à noter qu'il peut être prévu d'autres moyens de fermeture des ouvertures traversantes réalisées dans les capots des réservoirs 2, 3. On peut utiliser un bouchon sur chaque ouverture, ou un disque de fermeture monté rotatif au niveau de l'ouverture traversante correspondante, ou autre.

Une fois les opérations de calibration terminée, il peut être prévu encore une vis de réglage 12 pour le premier réservoir 2 et une vis de réglage 13 pour le second réservoir 3. Comme ces vis de réglage ont déjà été discutées en référence à la figure 6, la description détaillée ne sera pas répétée. Ces vis de réglage 12, 13 peuvent aussi être utilisées après fermeture des capots de chaque réservoir 2, 3, si une différence de pression est constatée avec le liquide, qui a légèrement bougé de sa position définie.

Il peut aussi être imaginé de disposer au-dessus de la portion d'affichage sur le cadran, une loupe non représentée pour augmenter la visibilité et lisibilité de l'indication de puissance du générateur thermoélectrique montrée dans la portion d'affichage.

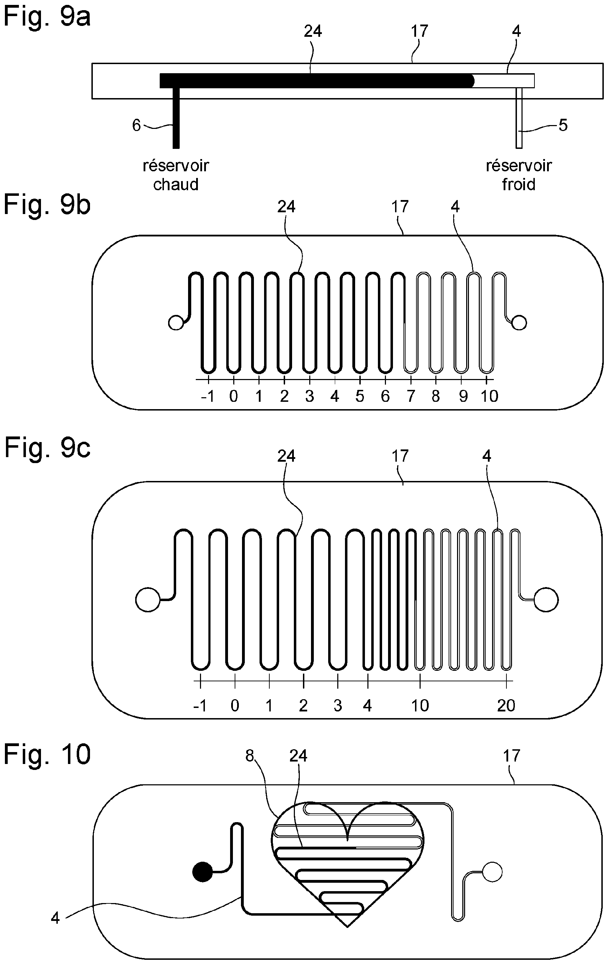

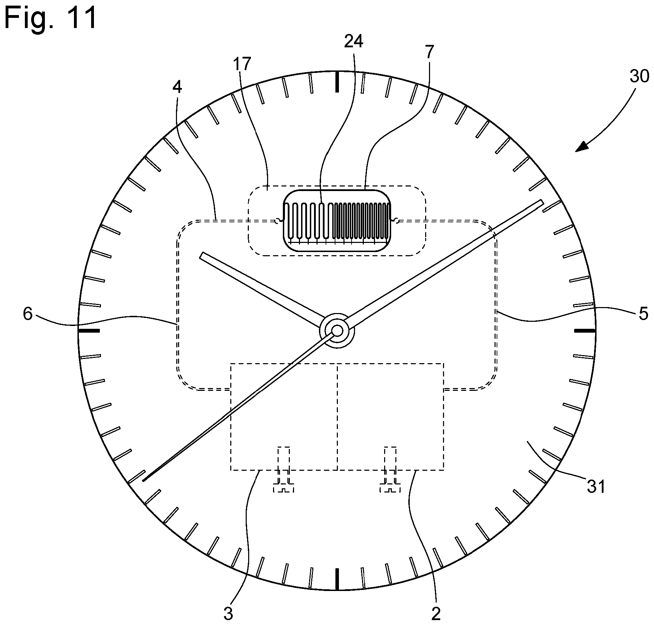

Les figures 9a, 9b et 9c représente une vue de côté et deux vues de dessus de la portion d'affichage 24 du dispositif indicateur. Cette portion d'affichage 24 peut être montrée à travers une fenêtre réalisée dans le cadran de montre pour être visible à l'extérieur de la boîte de montre, comme représenté à la figure 11 suivante. Cette fenêtre de la figure 11 peut être limitée de l'entrée à la sortie de la portion d'affichage, ce qui n'est pas montré sur ces figures 9a, 9b et 9c. La conduite tubulaire 4, qui peut être considérée comme du type capillaire, est réalisée intégralement dans une chambre micro fluidique 17 ayant la portion d'affichage 24. Cela remplace la portion d'affichage de la conduite tubulaire décrite précédemment, qui était principalement un verre ou un saphir capillaire. Cette conduite tubulaire 4 peut être réalisée sur un substrat transparent par toute méthode de gravure ou d'usinage similaire à un circuit intégré sur silicium. Et une fois la forme de la conduite tubulaire 4 réalisée sur le premier substrat transparent, un second substrat transparent est fixé sur le premier substrat transparent pour fermer complètement la chambre micro fluidique 17, qui comprend ainsi, intégré, la conduite tubulaire 4.

A la figure 9a, le dispositif indicateur comprend une première portion tubulaire flexible 5 reliée au premier réservoir froid, et à une sortie de la chambre micro fluidique 17, et une seconde portion tubulaire flexible 6 reliée au second réservoir chaud, et à une entrée de la chambre micro fluidique 17. Une partie du liquide huileux ou alcool est également dans la seconde portion tubulaire flexible 6, dont le diamètre intérieur est supérieur au diamètre d'une conduite tubulaire 4 intégrée dans la chambre micro fluidique 17. De l'entrée à la sortie de cette chambre micro fluidique 17, cette conduite tubulaire 4 définit des ondulations sous forme d'un serpentin. Dans ces conditions, peu de liquide a besoin d'être poussé de la seconde portion tubulaire flexible 6 dans la conduite tubulaire 4 de la chambre micro fluidique 17.

Cette chambre micro fluidique 17 comprend donc dans la portion d'affichage 24, une conduite tubulaire 4 sous forme d'un serpentin et d'espacement identique à la figure 9b de l'entrée à la sortie de la portion d'affichage 24, avec une graduation constante sur toute la portion d'affichage. Par contre, à la figure 9c, la chambre micro fluidique 17 comprend une première conduite tubulaire sous forme d'un serpentin et d'espacement identique, suivie par une seconde conduite tubulaire sous forme d'un serpentin, mais avec un espacement plus petit entre chaque ondulation que la première conduite. De cette manière, une graduation différente par pas de plus grande valeur peut être définie sur cette seconde conduite tubulaire jusqu'à la sortie en direction du réservoir froid.

La figure 10 montre une variante de réalisation de la chambre micro fluidique 17 comprenant la portion d'affichage 24. La conduite tubulaire 4 dans cette portion d'affichage 24 définit plusieurs ondulations sous forme d'un serpentin, délimitées dans une forme de cœur 8 pour fournir un aspect visuel différent. D'autres formes que seulement un cœur, peuvent être prévues pour l'agencement de la conduite tubulaire 4 dans la chambre micro fluidique 17.

La figure 11 montre une vue de dessus de la montre 30 au niveau du cadran 31 à travers lequel une fenêtre 7 est réalisée sur la portion d'affichage 24 de la chambre micro fluidique 17 comme présentée à la figure 9b décrite ci-dessus, du dispositif indicateur. Cette portion d'affichage 24 permet de montrer la puissance générée par le générateur thermoélectrique suite à une différence de températures entre le premier réservoir 2 et le second réservoir 3. Bien entendu, comme indiqué précédemment, le premier réservoir 2 peut ne pas être dans le même plan que le second réservoir 3 dans la boîte de montre 30.

Il est à noter que la chambre micro fluidique 17 peut aussi être fixée dans la fenêtre 7 de dimension équivalente ou sur le cadran 31 de montre 30. Dans ce cas, l'entrée de la chambre micro fluidique 17 est reliée à travers le cadran 31 à la seconde portion tubulaire flexible 6 en direction du second réservoir 3, alors que la sortie de la chambre micro fluidique 17 est reliée à travers le cadran 31 à la première portion tubulaire flexible 5 en direction du premier réservoir 2.

A partir de la description qui vient d'être faite, plusieurs variantes de réalisation du dispositif indicateur de puissance d'un générateur thermoélectrique sont possibles sans sortir du cadre de l'invention définie par les revendications suivantes. Il peut être prévu d'avoir un premier réservoir de dimension double ou de la moitié de la dimension du second réservoir. La portion d'affichage peut être composée de plusieurs parties de conduite tubulaire de diamètre intérieur différent. La portion d'affichage peut aussi être disposée sur le cadran d'une montre.

**Revendications**

1. Dispositif indicateur (1) de puissance d'un générateur thermoélectrique (10) d'une montre (30), le dispositif indicateur (1) comprenant un premier réservoir (2) de fluide gazeux, un second réservoir (3) de fluide gazeux, et au moins une conduite tubulaire (4) reliant les deux réservoirs (2, 3), le premier réservoir (2) étant destiné à être placé sur une surface supérieure du générateur thermoélectrique (10) dans une boîte de montre (30), alors que le second réservoir (3) est destiné à être placé sur une surface inférieure du générateur thermoélectrique (10) en contact du fond d'une boîte de montre (30), la conduite tubulaire (4) étant de type capillaire et comprend dans une portion intermédiaire (9) un liquide faisant barrière au fluide gazeux des deux réservoirs (2, 3) et permettant dans une portion d'affichage (24) dans la portion intermédiaire (9), de fournir une indication de la puissance du générateur par une mesure de différence de températures des deux réservoirs (2, 3), la portion d'affichage (24) étant destinée à être disposée dans la boîte de montre (30) pour être visible de l'extérieur de la boîte de montre (30).

2. Dispositif indicateur (1) selon la revendication 1, **caractérisé en ce que** le liquide en partie visible dans la portion d'affichage (24) pour indiquer une puissance du générateur thermoélectrique (10), est un liquide coloré huileux ou alcool, et **en ce que** la portion d'affichage (24) est adaptée pour être disposée sur un cadran (31) de la montre (30), ou sous le cadran (31) de la montre (30) et visible à travers une fenêtre traversante (7) du cadran (31) de la montre (30).

3. Dispositif indicateur (1) selon la revendication 1, **caractérisé en ce que** la portion intermédiaire (9) de la conduite tubulaire (4) est un verre ou un saphir capillaire.

4. Dispositif indicateur (1) selon la revendication 3, **caractérisé en ce qu'**une première extrémité de la portion intermédiaire (9) est reliée par une première portion tubulaire flexible (5) au premier réservoir (2), et **en ce qu'**une seconde extrémité de la portion intermédiaire (9) est reliée par une seconde portion tubulaire flexible (6) au second réservoir (3).

5. Dispositif indicateur (1) selon la revendication 3, **caractérisé en ce que** la portion intermédiaire (9) comprend la portion d'affichage (24) d'un côté en direction du premier réservoir (2), et un réservoir de liquide (25) d'un côté en direction du second réservoir (3), le réservoir de liquide (25) à l'entrée de la portion d'intermédiaire (9) étant directement lié à la portion d'affichage (24) à la sortie de la portion intermédiaire (9) pour former le verre ou saphir capillaire en une pièce.

6. Dispositif indicateur (1) selon la revendication 5, **caractérisé en ce que** le réservoir de liquide (25) à l'entrée de la portion d'intermédiaire (9) est lié à la portion d'affichage (24) à la sortie de la portion intermédiaire (9) pour former le verre ou saphir capillaire en une pièce dans une direction rectiligne de l'entrée à la sortie de la portion intermédiaire (9).

7. Dispositif indicateur (1) selon la revendication 5, **caractérisé en ce que** le réservoir de liquide (25) est d'une forme grosse goutte pour comprendre suffisamment de liquide pour assurer un volume rempli pour l'affichage de l'indication de puissance dans la portion d'affichage (24).

8. Dispositif indicateur (1) selon la revendication 5, **caractérisé en ce que** le réservoir de liquide (25) est sous une forme cylindrique ayant un diamètre intérieur supérieur au diamètre intérieur à l'entrée de la portion d'affichage (24) pour comprendre suffisamment de liquide pour assurer un volume rempli pour l'affichage de l'indication de puissance dans la portion d'affichage (24).

9. Dispositif indicateur (1) selon l'une des revendications 7 et 8, **caractérisé en ce que** la portion d'affichage (24) comprend à l'entrée une première partie linéaire de forme cylindrique suivie par une seconde partie non linéaire, dont le diamètre intérieur augmente jusqu'à la sortie de la portion l'affichage en direction du premier réservoir (2).

10. Dispositif indicateur (1) selon la revendication 9, **caractérisé en ce que** la seconde partie non linéaire de la portion d'affichage (24) augmente linéairement de la première partie linéaire à la sortie de la portion d'affichage (24).

11. Dispositif indicateur (1) selon la revendication 1, **caractérisé en ce qu'**une partie de la conduite tubulaire (4) est intégrée dans une chambre micro fluidique (17), qui comprend la portion d'affichage (24) dans la portion intermédiaire (9), **en ce que** le dispositif indicateur (1) comprend une première portion tubulaire flexible (5) reliée au premier réservoir (2) et à une sortie de la chambre micro fluidique (17), et **en ce que** le dispositif indicateur (1) comprend une seconde portion tubulaire flexible (6) reliée au second réservoir (3) et à une entrée de la chambre micro fluidique (17).

12. Dispositif indicateur (1) selon la revendication 11, **caractérisé en ce que** la chambre micro fluidique (17) comprend une conduite tubulaire réalisée avec des ondulations sous forme d'un serpentin de l'entrée à la sortie de la chambre micro fluidique (17).

13. Dispositif indicateur (1) selon la revendication 12, **caractérisé en ce que** la conduite tubulaire dans la chambre micro fluidique (17) est constituée d'une première conduite avec des ondulations sous forme d'un serpentin, et d'espacement identique, suivie par une seconde conduite avec des ondulations sous forme d'un serpentin, mais avec un espacement plus petit entre chaque ondulation que la première conduite de manière à définir une graduation différente par pas de plus grande valeur sur cette seconde conduite jusqu'à la sortie en direction du premier réservoir (2).

14. Dispositif indicateur (1) selon la revendication 11, **caractérisé en ce que** la seconde portion tubulaire flexible (6) comprend une partie du liquide, qui est un liquide huileux ou alcool, pour servir de réservoir de liquide, le diamètre intérieur de la seconde portion tubulaire flexible (6) au niveau de l'entrée de la chambre micro fluidique (17), étant supérieur au diamètre de la conduite tubulaire dans la chambre micro fluidique (17).

15. Dispositif indicateur (1) selon la revendication 1, **caractérisé en ce qu'**il comprend des moyens de réglage du volume de fluide gazeux dans les réservoirs (2, 3) pour calibrer initialement l'indication affichée par le liquide dans la portion d'affichage (24) de la portion intermédiaire (9) de la conduite tubulaire (4), **en ce que** les moyens de réglage sont constitués par une première vis de réglage (12) vissée dans le premier réservoir (2), et par une seconde vis de réglage (13) vissée dans le second réservoir (3), en vissant ou dévissant au moins une des vis (12, 13) vers l'intérieur ou l'extérieur de la chambre des réservoirs (2, 3), le volume de fluide gazeux pouvant être ajusté pour calibrer la position initiale du liquide dans la portion d'affichage (24).

16. Dispositif indicateur (1) selon la revendication 1, **caractérisé en ce qu'**il comprend des moyens de réglage constitués par une dérivation tubulaire (14) reliant une chambre du premier réservoir (2) à une chambre du second réservoir (3) pour ajuster le volume de fluide gazeux dans les deux réservoirs (2, 3) pour calibrer la position initiale du liquide dans la portion d'affichage (24).

17. Dispositif indicateur (1) selon la revendication 1, **caractérisé en ce qu'**il comprend des moyens de réglage constitués par une ouverture traversante (21), qui est réalisée dans le capot ou couvercle (3') du second réservoir (3) pour amener un fluide gazeux par cette ouverture (21) pour le réglage de la position du liquide dans la portion intermédiaire (9) de la conduite tubulaire (4), et par une ouverture traversante réalisée dans le capot ou couvercle du premier réservoir (2) pour amener un fluide gazeux par cette ouverture du premier réservoir (2) pour le réglage de la position du liquide dans la portion intermédiaire (9) de la conduite tubulaire (4), **en ce que** les ouvertures des capots sont fermées par une plaque de fermeture (23) après calibration, et **en ce que** les moyens de réglage sont constitués en outre par une première vis de réglage (12) vissée dans le premier réservoir (2), et par une seconde vis de réglage (13) vissée dans le second réservoir (3), en vissant ou dévissant au moins une des vis (12, 13) vers l'intérieur ou l'extérieur de la chambre des réservoirs (2, 3), le volume de fluide gazeux pouvant être ajusté pour calibrer la position initiale du liquide dans la portion d'affichage (24).

18. Dispositif indicateur (1) selon l'une des revendications 15 à 17, **caractérisé en ce qu'**il comprend un miroir (15) disposé sous la portion d'affichage (24) pour améliorer la visibilité du liquide dans la portion d'affichage (24).

19. Montre (30) comprenant un générateur thermoélectrique (10) et au moins un dispositif indicateur (1) de puissance du générateur thermoélectrique (10) selon l'une des revendications précédentes.

20. Montre (30) selon la revendication 19, **caractérisée en ce qu'**elle comprend un cadran (31), et **en ce que** la portion d'affichage (24) du dispositif indicateur (1) est disposée sur le cadran (31) ou sous le cadran (31) pour être visible à l'extérieur de la boîte de montre, à travers une fenêtre traversante (7) du cadran (31).

21. Montre (30) selon la revendication 19, **caractérisée en ce qu'**elle comprend le premier réservoir (2) disposé sur une surface supérieure du générateur thermoélectrique (10), et le second réservoir (3) disposé sur une surface inférieure du générateur thermoélectrique (10) en contact direct du fond de la boîte de montre (30), le premier réservoir (2) étant relié au second réservoir (3) par une conduite tubulaire (4) de type capillaire.

## Patentansprüche

1. Anzeigevorrichtung (1) für die Leistung eines thermoelektrischen Generators (10) einer Uhr (30), wobei die Anzeigevorrichtung (1) ein erstes Reservoir (2) für ein gasförmiges Fluid, ein zweites Reservoir (3) für ein gasförmiges Fluid und mindestens eine rohrförmige Leitung (4), die die beiden Reservoire (2, 3) verbindet, umfasst, wobei das erste Reservoir (2) dazu bestimmt ist, auf einer Oberseite des thermoelektrischen Generators (10) in einem Uhrengehäuse (30) angeordnet zu sein, während das zweite Reservoir (3) dazu bestimmt ist, auf einer Unterseite des thermoelektrischen Generators (10) in Kontakt mit dem Boden eines Uhrengehäuses (30) angeordnet zu sein,
die rohrförmige Leitung (4) vom Kapillartyp ist und in einem Zwischenbereich (9) eine Flüssigkeit enthält, die das gasförmige Fluid der beiden Reservoire (2, 3) sperrt, und in einem Anzeigeabschnitt (24) in dem Zwischenbereich (9) eine Anzeige von Leistung des Generators durch eine Messung der Temperaturdifferenz der beiden Reservoire (2, 3) ermöglicht, wobei der Anzeigeabschnitt (24) dazu bestimmt ist, in dem Uhrengehäuse (30) angeordnet zu sein, um von außerhalb des Uhrengehäuses (30) sichtbar zu sein.

2. Anzeigevorrichtung (1) nach Anspruch 1, **dadurch gekennzeichnet, dass** die Flüssigkeit, die in dem Anzeigeabschnitt (24) teilweise sichtbar ist, um eine Leistung des thermoelektrischen Generators (10) anzugeben, eine ölige farbige Flüssigkeit oder Alkohol ist, und dass der Anzeigeabschnitt (24) dafür ausgelegt ist, auf einem Zifferblatt (31) der Uhr (30) oder unter dem Zifferblatt (31) der Uhr (30), wo er durch ein Durchgangsfenster (7) des Zifferblatts (31) der Uhr (30) sichtbar ist, angeordnet zu sein.

3. Anzeigevorrichtung (1) nach Anspruch 1, **dadurch gekennzeichnet, dass** der Zwischenbereich (9) der rohrförmigen Leitung (4) ein Glas oder ein Kapillarsaphir ist.

4. Anzeigevorrichtung (1) nach Anspruch 3, **dadurch gekennzeichnet, dass** ein erstes Ende des Zwischenbereichs (9) durch einen ersten flexiblen rohrförmigen Abschnitt (5) mit dem ersten Reservoir (2) verbunden ist und dass ein zweites Ende des Zwischenbereichs (9) durch einen zweiten flexiblen rohrförmigen Abschnitt (6) mit dem zweiten Reservoir (3) verbunden ist.

5. Anzeigevorrichtung (1) nach Anspruch 3, **dadurch gekennzeichnet, dass** der Zwischenbereich (9) einen Anzeigeabschnitt (24) auf der Seite in Richtung des ersten Reservoirs (2) und ein Flüssigkeitsreservoir (25) auf der Seite in Richtung des zweiten Reservoirs (3) umfasst, wobei das Flüssigkeitsreservoir (25) am Eingang des Zwischenbereichs (9) direkt verbunden ist mit dem Anzeigeabschnitt (24) am Ausgang des Zwischenbereichs (9), um das Glas oder den Kapillarsaphir einteilig zu bilden.

6. Anzeigevorrichtung (1) nach Anspruch 5, **dadurch gekennzeichnet, dass** das Flüssigkeitsreservoir (25) am Eingang des Zwischenbereichs (9) mit dem Anzeigeabschnitt (24) am Ausgang des Zwischenbereichs (9) verbunden ist, um das Glas oder den Kapillarsaphir in einer geraden Richtung vom Eingang zum Ausgang des Zwischenbereichs (9) in einem Stück zu formen.

7. Anzeigevorrichtung (1) nach Anspruch 5, **dadurch gekennzeichnet, dass** das Flüssigkeitsreservoir (25) die Form eines großen Tropfens hat, um ausreichend Flüssigkeit aufzunehmen, um ein gefülltes Volumen für die Anzeige der Leistungsangabe in dem Anzeigeabschnitt (24) zu gewährleisten.

8. Anzeigevorrichtung (1) nach Anspruch 5, **dadurch gekennzeichnet, dass** das Flüssigkeitsreservoir (25) eine zylindrische Form mit einem Innendurchmesser hat, der größer als der Innendurchmesser am Eingang des Anzeigeabschnitts (24) ist, um ausreichend Flüssigkeit zu enthalten, um ein gefülltes Volumen für die Anzeige der Leistungsangabe in dem Anzeigeabschnitt (24) zu gewährleisten.

9. Anzeigevorrichtung (1) nach einem der Ansprüche 7 und 8, **dadurch gekennzeichnet, dass** der Anzeigeabschnitt (24) am Eingang einen ersten linearen Teil in zylindrischer Form umfasst, gefolgt von einem zweiten nicht linearen Teil, dessen Innendurchmesser bis zum Ausgang des Anzeigeabschnitts in Richtung des ersten Reservoirs (2) zunimmt.

10. Anzeigevorrichtung (1) nach Anspruch 9, **dadurch gekennzeichnet, dass** der zweite nicht lineare Teil des Anzeigeabschnitts (24) linear von dem ersten linearen Teil am Ausgang des Anzeigeabschnitts (24) ansteigt.

11. Anzeigevorrichtung (1) nach Anspruch 1, **dadurch gekennzeichnet, dass** ein Teil der rohrförmigen Leitung (4) in eine Mikrofluidkammer (17) integriert ist, die den Anzeigeabschnitt (24) in dem Zwischenbereich (9) umfasst, dass die Anzeigevorrichtung (1) einen ersten flexiblen rohrförmigen Abschnitt (5) umfasst, der mit dem ersten Reservoir (2) und mit einem Auslass der Mikrofluidkammer (17) verbunden ist, und dass die Anzeigevorrichtung (1) einen zweiten flexiblen rohrförmigen Abschnitt (6) umfasst, der mit dem zweiten Reservoir (3) und mit einem Einlass der Mikrofluidkammer (17) verbunden ist.

12. Anzeigevorrichtung (1) nach Anspruch 11, **dadurch gekennzeichnet, dass** die Mikrofluidkammer (17) eine rohrförmige Leitung umfasst, die mit schlangenförmigen Wellen vom Einlass zum Auslass der Mikrofluidkammer (17) ausgeführt ist.

13. Anzeigevorrichtung (1) nach Anspruch 12, **dadurch gekennzeichnet, dass** die rohrförmige Leitung in der Mikrofluidkammer (17) aus einer ersten Leitung mit schlangenförmigen Wellen und gleichem Abstand besteht, gefolgt von einer zweiten Leitung mit schlangenförmigen Wellen, aber mit kleinerem Abstand zwischen jeder Welle als die erste Leitung, so dass eine unterschiedliche Skalierung in größeren Schritten auf dieser zweiten Leitung bis zum Austritt in Richtung des ersten Reservoirs (2) definiert ist.

14. Anzeigevorrichtung (1) nach Anspruch 11, **dadurch gekennzeichnet, dass** der zweite flexible rohrförmige Abschnitt (6) einen Teil der Flüssigkeit, die eine ölige Flüssigkeit oder Alkohol ist, umfasst, um als Flüssigkeitsreservoir zu dienen, wobei der Innendurchmesser des zweiten flexiblen rohrförmigen Abschnitts (6) an der Stelle des Einlasses der Mikrofluidkammer (17) größer ist als der Durchmesser der rohrförmigen Leitung in der Mikrofluidkammer (17).

15. Anzeigevorrichtung (1) nach Anspruch 1, **dadurch gekennzeichnet, dass** sie Mittel zum Einstellen des Volumens des gasförmigen Fluids in den Reservoiren (2, 3) umfasst, um anfänglich die Anzeige, die durch die Flüssigkeit in dem Anzeigeabschnitt (24) des Zwischenbereichs (9) der rohrförmigen Leitung (4) angezeigt wird, zu kalibrieren, dass die Einstellmittel bestehen aus einer ersten Einstellschraube (12), die in das erste Reservoir (2) eingeschraubt ist, und aus eine zweiter Einstellschraube (13), die in das zweite Reservoir (3) eingeschraubt ist, indem mindestens eine der Schrauben (12, 13) einwärts oder auswärts des Raums des Reservoirs (2, 3) ein- oder ausgeschraubt wird, wobei das Volumen des gasförmigen Fluids einstellbar ist, um die Anfangsposition der Flüssigkeit in dem Anzeigeabschnitt (24) zu kalibrieren.

16. Anzeigevorrichtung (1) nach Anspruch 1, **dadurch gekennzeichnet, dass** sie Regulierungsmittel enthält, die durch eine rohrförmige Abzweigung (14) gebildet ist, die eine Kammer des ersten Vorratsbehälters (2) mit einer Kammer des zweiten Vorratsbehälters (3) verbindet, um das Volumen des gasförmigen Fluids in den beiden Vorratsbehältern (2, 3) einzustellen, um die anfängliche Position der Flüssigkeit in dem Anzeigeabschnitt (24) zu kalibrieren.

17. Anzeigevorrichtung (1) nach Anspruch 1, **dadurch gekennzeichnet, dass** sie Einstellmittel umfasst, die aus einer Durchgangsöffnung (21) gebildet ist, die in der Haube oder dem Deckel (3') des zweiten Reservoirs (3) ausgebildet ist, um durch diese Öffnung (21) ein gasförmiges Fluid zur Einstellung der Position der Flüssigkeit in dem Zwischenbereich (9) der rohrförmigen Leitung (4) zuzuführen, und durch eine Durchgangsöffnung in der Haube oder dem Deckel des ersten Reservoirs (2), um ein gasförmiges Medium durch diese Öffnung des ersten Reservoirs (2) zur Einstellung der Position der Flüssigkeit in dem Zwischenabschnitt (9) der rohrförmigen Leitung (2) zuzuführen, dass die Öffnungen der Hauben durch eine Verschlussplatte (23) nach der Kalibrierung verschlossen werden, und dass die Einstellmittel außerdem aus einer ersten Einstellschraube (12) bestehen, die in das erste Reservoir (2) eingeschraubt ist, und aus einer zweiten Einstellschraube (13), die in das zweite Reservoir (3) eingeschraubt ist, indem mindestens eine der Schrauben (12, 13) in Richtung des Inneren oder des Äußeren des Raums des Reservoirs (2, 3) hinein oder heraus geschraubt wird, wobei das Volumen des gasförmigen Fluids einstellbar ist, um die Anfangsposition der Flüssigkeit in dem Anzeigeabschnitt (24) zu kalibrieren.

18. Anzeigevorrichtung (1) nach einem der Ansprüche 15 bis 17, **dadurch gekennzeichnet, dass** sie einen Spiegel (15) umfasst, der unter dem Anzeigeabschnitt (24) angeordnet ist, um die Sichtbarkeit der Flüssigkeit in dem Anzeigeabschnitt (24) zu verbessern.

19. Uhr (30), umfassend einen thermoelektrischen Generator (10) und mindestens eine Anzeigevorrichtung (1) für die Leistung des thermoelektrischen Generators (10) nach einem der vorhergehenden Ansprüche.

20. Uhr (30) nach Anspruch 19, **dadurch gekennzeichnet, dass** sie ein Zifferblatt (31) aufweist, und das der Anzeigeabschnitt (24) der Anzeigevorrichtung (1) auf dem Zifferblatt (31) oder unter dem Zifferblatt (31), wo sie von außerhalb des Uhrengehäuses durch ein Durchgangsfenster (7) des Zifferblatts (31) sichtbar ist, angeordnet ist.

21. Uhr (30) nach Anspruch 19, **dadurch gekennzeichnet, dass** sie das erste Reservoir (2), das auf einer oberen Fläche des thermoelektrischen Generators (10) angeordnet ist, und das zweite Reservoir (3) enthält, das auf einer unteren Fläche des thermoelektrischen Generators (10) in direktem Kontakt mit dem Boden des Uhrengehäuses (30) angeordnet ist, wobei das erste Reservoir (2) mit dem zweiten Reservoir (3) durch eine rohrförmige Leitung (4) des Kapillartyps verbunden ist.

**Claims**

1. A power indicator device (1) of a thermoelectric generator (10) of a watch (30), the indicator device (1) comprising a first gas fluid reservoir (2), a second gas fluid reservoir (3), and at least one tubular conduit (4) connecting the two reservoirs (2, 3), the first reservoir (2) being intended to be placed on an upper surface of the thermoelectric generator (10) in a watch case (30), while the second reservoir (3) is intended to be placed on a lower surface of the thermoelectric generator (10) in contact with the back of a watch case (30),
   the tubular conduit (4) being of the capillary type and comprising in an intermediate portion (9) a liquid forming a barrier to the gas fluid of the two reservoirs (2, 3) and allowing in a display portion (24) in the intermediate portion (9), to provide an indication of the power of the generator by measuring the temperature difference of the two reservoirs (2, 3), the display portion (24) being intended to be disposed in the watch case (30) to be visible from the outside of the watch case (30).

2. The indicator device (1) according to claim 1, **characterised in that** the liquid partially visible in the display portion (24) for indicating a power of the thermoelectric generator (10), is an oily or alcohol coloured liquid, and **in that** the display portion (24) is adapted to be disposed on a dial (31) of the watch (30), or under the dial (31) of the watch (30) and visible through a through-window (7) of the dial (31) of the watch (30).

3. The indicator device (1) according to claim 1, **characterised in that** the intermediate portion (9) of the tubular conduit (4) is a glass or a capillary sapphire.

4. The indicator device (1) according to claim 3, **characterised in that** a first end of the intermediate portion (9) is connected by a first flexible tubular portion (5) to the first reservoir (2), and **in that** a second end of the intermediate portion (9) is connected by a second flexible tubular portion (6) to the second reservoir (3).

5. The indicator device (1) according to claim 3, **characterised in that** the intermediate portion (9) comprises the display portion (24) on one side in the direction of the first reservoir (2), and a liquid reservoir (25) on one side in the direction of the second reservoir (3), the liquid reservoir (25) at the inlet of the intermediate portion (9) being directly connected to the display portion (24) at the outlet of the intermediate portion (9) to form the capillary glass or sapphire in one piece.

6. The indicator device (1) according to claim 5, **characterised in that** the liquid reservoir (25) at the inlet of the intermediate portion (9) is connected to the display portion (24) at the outlet of the intermediate portion (9) to form the capillary glass or sapphire in one piece in a rectilinear direction from the inlet to the outlet of the intermediate portion (9).

7. The indicator device (1) according to claim 5, **characterised in that** the liquid reservoir (25) is in the shape of a large drop to comprise sufficient liquid to ensure a filled volume for the display of the power indication in the display portion (24).

8. The indicator device (1) according to claim 5, **characterised in that** the liquid reservoir (25) is in a cylindrical shape having an internal diameter larger than the internal diameter at the input of the display portion (24) to comprise sufficient liquid to ensure a filled volume for the display of the power indication in the display portion (24).

9. The indicator device (1) according to any one of claims 7 and 8, **characterised in that** the display portion (24) comprises at the input a first linear part of cylindrical shape followed by a second non-linear part, the internal diameter of which increases to the output of the display portion in the direction of the first reservoir (2).

10. The indicator device (1) according to claim 9, **characterised in that** the second non-linear part of the display portion (24) increases linearly from the first linear part at the output of the display portion (24).

11. The indicator device (1) according to claim 1, **characterised in that** a part of the tubular conduit (4) is integrated in a microfluidic chamber (17), which comprises the display portion (24) in the intermediate portion (9), **in that** the indicator device (1) comprises a first flexible tubular portion (5) connected to the first reservoir (2) and to an outlet of the microfluidic chamber (17), and **in that** the indicator device (1) comprises a second flexible tubular portion (6) connected to the second reservoir (3) and to an inlet of the microfluidic chamber (17).

12. The indicator device (1) according to claim 11, **characterised in that** the microfluidic chamber (17) comprises a tubular conduit made with corrugations in the shape of a coil from the inlet to the outlet of the microfluidic chamber (17).

13. The indicator device (1) according to claim 12, **characterised in that** the tubular conduit in the microfluidic chamber (17) consists of a first conduit with corrugations in the shape of a coil, and identical spacing, followed by a second conduit with corrugations in the shape of a coil, but with a smaller spacing between each corrugation than the first conduit so as to define a different graduation in steps of greater value on this second conduit to the outlet in the direction of the first reservoir (2).

14. The indicator device (1) according to claim 11, **characterised in that** the second flexible tubular portion (6) comprises part of the liquid, which is an oily liquid or alcohol, to serve as a liquid reservoir, the internal diameter of the second flexible tubular portion (6) at the inlet of the microfluidic chamber (17), being larger than the diameter of the tubular conduit in the microfluidic chamber (17).

15. The indicator device (1) according to claim 1, **characterised in that** it comprises means for adjusting the volume of the gas fluid in the reservoirs (2, 3) to initially calibrate the indication displayed by the liquid in the display portion (24) of the intermediate portion (9) of the tubular conduit (4), **in that** the adjustment means are constituted by a first adjustment screw (12) screwed into the first reservoir (2), and by a second adjustment screw (13) screwed into the second reservoir (3), by screwing or unscrewing at least one of the screws (12, 13) towards the inside or outside of the chamber of the reservoirs (2, 3), the volume of gas fluid can be adjusted to calibrate the initial position of the liquid in the display portion (24).

16. The indicator device (1) according to claim 1, **characterised in that** it comprises adjustment means constituted by a tubular branch (14) connecting a chamber of the first reservoir (2) to a chamber of the second reservoir (3) for adjusting the volume of gas fluid in the two reservoirs (2, 3) to calibrate the initial position of the liquid in the display portion (24).

17. The indicator device (1) according to claim 1, **characterised in that** it comprises adjustment means constituted by a through opening (21), which is formed in the cover or lid (3') of the second reservoir (3) to supply a gas fluid through this opening (21) for adjusting the position of the liquid in the intermediate portion (9) of the tubular conduit (4), and through a through opening made in the cover or lid of the first reservoir (2) to supply a gas fluid through this opening of the first reservoir (2) for adjusting the position of the liquid in the intermediate portion (9) of the tubular conduit (4), **in that** the openings of the covers are closed by a closing plate (23) after calibration, and **in that** the adjustment means are further constituted by a first adjustment screw (12) screwed into the first reservoir (2), and by a second adjustment screw (13) screwed into the second reservoir (3), by screwing or unscrewing at least one of the screws (12, 13) towards the inside or outside of the chamber of the reservoirs (2, 3), the volume of gas fluid can be adjusted to calibrate the initial position of the liquid in the display portion (24).

18. The indicator device (1) according to any one of claims 15 to 17, **characterised in that** it comprises a mirror (15) disposed under the display portion (24) to improve the visibility of the liquid in the display portion (24).

19. A watch (30) comprising a thermoelectric generator (10) and at least one power indicator device (1) of the thermoelectric generator (10) according to any one of the preceding claims.

20. The watch (30) according to claim 19, **characterised in that** it comprises a dial (31), and **in that** the display portion (24) of the indicator device (1) is disposed on the dial (31) or under the dial (31) to be visible outside the watch case, through a through-window (7) of the dial (31).

21. The watch (30) according to claim 19, **characterised in that** it comprises the first reservoir (2) disposed on an upper surface of the thermoelectric generator (10), and the second reservoir (3) disposed on a lower surface of the thermoelectric generator (10) in direct contact with the back of the watch case (30), the first reservoir (2) being connected to the second reservoir (3) by a tubular conduit (4) of the capillary type.

# Fig. 1

# Fig. 2a

# Fig. 2b

# Fig. 2c

EP 3 904 966 B1

## Fig. 3

Réservoir chaud ←

Réservoir froid →

25    9    δT    24    4

-1 0 1 2 3 4 6    8    15    30

## Fig. 4

réservoir huile    linéaire  non linéaire

1    25    7    Chrons/s    24    4

-1 0 1 2 3 4 6    8    15 30

6    verre capillaire    5

9

3    13    12    2

EP 3 904 966 B1

Fig. 5

Fig. 6

Fig. 7

Fig. 8

Fig. 9a

24    17    4

6

réservoir
chaud

5

réservoir
froid

Fig. 9b

24    17    4

-1  0  1  2  3  4  5  6  7  8  9  10

Fig. 9c

24    17    4

-1   0   1   2   3   4   10   20

Fig. 10

8   24    17

4

Fig. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012162469 A2
- CH 701885 B1
- EP 1939700 B1